**Europäisches Patentamt**

**European Patent Office**

**Office européen des brevets**

(19)

(11) Veröffentlichungsnummer: **0 057 734**
**B1**

(12)

# EUROPÄISCHE PATENTSCHRIFT

(45) Veröffentlichungstag der Patentschrift:
**18.12.85**

(51) Int. Cl.⁴: **G 03 F 5/12**

(21) Anmeldenummer: **81100822.6**

(22) Anmeldetag: **05.02.81**

(54) **Verfahren zur Herstellung eines Kornrasters.**

(43) Veröffentlichungstag der Anmeldung:
**18.08.82 Patentblatt 82/33**

(45) Bekanntmachung des Hinweises auf die Patenterteilung:
**18.12.85 Patentblatt 85/51**

(84) Benannte Vertragsstaaten:
**AT BE CH DE FR GB IT LI LU NL SE**

(56) Entgegenhaltungen:
**EP - A - 0 000 552**
**FR - A - 481 156**

(73) Patentinhaber: **Licht Druck AG., Claridenstrasse 36, CH-8002 Zürich (CH)**

(72) Erfinder: **Müller, Hans Ernst, Höhenstrasse 5, CH-8157 Dielsdorf (CH)**

(74) Vertreter: **Blum, Rudolf Emil Ernst, c/o E. Blum & Co Patentanwälte Vorderberg 11, CH-8044 Zürich (CH)**

## Beschreibung

Die Erfindung bezieht sich auf ein Verfahren zur Herstellung eines Kornrasters, wobei das Korn einer lichtdurchlässigen Schicht auf einer Glasplatte auf ein lichtempfindliches Material umkopiert wird.

Bekannte Kornraster weisen unregelmässig verteilte flächenähnlich wirkende Strukturen auf. Diese Strukturen können auf verschiedene Weise erzeugt werden.

Aus der FR-A-1 475 816 ist ein Kornraster bekannt, bei dem eine Kunststoff-Folie auf eine Glasplatte aufgebracht wird. Danach wird durch Belichten das Korn umkopiert.

Die mit diesem Kornraster erzeugten Strukturen, die auch im damit erzeugten Druck erkennbar sind, sind klar abgrenzbar. Mit diesem Kornraster kann lediglich die Moirébildung verhindert werden. Mit diesem Kornraster ist es nicht möglich, echte Halbtöne wie beim Lichtdruckverfahren zu drucken. Ferner ist die Herstellung kompliziert und sehr aufwendig.

Ziel der Erfindung ist es, die angegebenen Nachteile zu beheben.

Die Erfindung, wie sie im Patentanspruch gekennzeichnet ist, löst die Aufgabe, ein Verfahren zur Herstellung eines Kornrasters zu schaffen, mit dem Kornraster sehr hoher Auflösung billiger und einfacher herstellbar sind.

Die durch die Erfindung erreichbaren Vorteile sind im wesentlichen darin zu sehen, dass bei der Anwendung des nach dem erfindungsgemässen Verfahren hergestellten Kornrasters die Zerlegung der Halbtöne im Vergleich zum Lichtdruckverfahren sehr viel feiner ist sowie eine genaue und tonwertrichtige Wiedergabe einer Vorlage und die Herstellung von Drucken grosser Originaltreue möglich wird.

Aus der FR-A-2 026 473 ist ein Verfahren zur lithographischen Wiedergabe einer Originalkopie bekannt, bei dem ein Kornraster verwendet wird und das Korn einer sandgestrahlten und mit Gelatine bedeckten Glasplatte auf ein lichtempfindliches Material umkopiert wird.

Demgegenüber hat das nach dem erfindungsgemässen Verfahren hergestellte Kornraster eine feinere Auflösung und ist einfacher herstellbar.

Aus der FR-A-481 156 ist ein Verfahren zur Herstellung einer Rasterplatte bekannt, bei dem auf eine Glasplatte Asphaltpulver aufgebracht und dann mittels Chloroformdämpfen vollständig aufgelöst wird. Die aufgelöste Schicht lässt man dann verfestigen, wobei auf der Platte halbkugelförmige voneinander getrennte Vorsprünge gebildet werden.

Dieses Kornraster unterscheidet sich von periodischen Rastern nur durch seine willkürliche Verteilung der klar abgrenzbaren Strukturen.

Im Gegensatz dazu hat das nach dem erfindungsgemässen Verfahren erzeugte Kornraster eine bedeutend feinere Zerlegung, d.h. auf der Kopie werden nahezu strukturlose Halbtöne erzeugt.

Das Kornraster wird hergestellt, indem auf einer sauberen, kratzer- und staubfreien Glasplatte eine dünne Schicht einer Asphaltlösung aufgegossen wird.

Als Asphaltlösung wird die aus dem Asphalt Kopierverfahren oder dem Photochrom-Verfahren bekannte Lösung verwendet.

Die Asphaltlösung lässt man danach unter Lichteinwirkung trocknen, wodurch der Asphalt unlöslich wird und ein sehr feines Korn entsteht.

Anschliessend wird das Korn im Kontaktverfahren auf ein lichtempfindliches Material umkopiert.

Bei Untersuchungen wurde festgestellt, dass die Kornzahl pro cm beim erfindungsgemässen Kornraster bei 300 liegt. Demgegenüber liegen die Kornzahlen beim Lichtdruck bei 230 und bei herkömmlichen Kornrastern bei 180.

Durch Doppelbelichtung kann die Auflösung noch verbessert werden, so dass eine Kornzahl von ca. 400 erreicht wird.

### Patentanspruch

1. Verfahren zur Herstellung eines Kornrasters, wobei das Korn einer lichtdurchlässigen Schicht auf einer Glasplatte auf ein lichtempfindliches Material umkopiert wird, dadurch gekennzeichnet, dass man eine Asphaltlösung auf die Glasplatte aufträgt und unter Lichteinwirkung trocknen lässt, um das Korn zu bilden.

### Claim

Method for manufacturing a granulated screen, whereby said grain of a light-transmissive layer on a plate of glass is optical printed to a light-sensitive material, characterized in that one applies a solution of asphalt onto said plate of glass and dries it under action of light in order to form said grain.

### Revendication

Procédé pour la production d'une trame granulée, dans lequel le grain d'une couche transparente sur une plaque de verre est copié sur un matériau photo-sensible, caractérisé en ce que l'on applique sur la plaque de verre une solution de bitume, dont le séchage sous l'action de lumière provoque la formation du grain.